# EUROPEAN PATENT SPECIFICATION

(11) **EP 4 220 730 B1**
(45) Date of publication and mention of the grant of the patent: **11.12.2024**
(21) Application number: 22153881.2
(22) Date of filing: 28.01.2022
(51) Int. Cl.: H01L 29/06, H01L 29/08, H01L 29/10, H01L 29/40, H01L 29/66, H01L 29/739, H01L 29/78

(54) **METHOD FOR PRODUCING VERTICAL TRENCH-GATE MOSFETS OR IGBTS AND CORRESPONDING SEMICONDUCTOR DEVICE**
HERSTELLUNGSVERFAHREN FÜR VERTIKALE TRENCH-GATE MOSFETS ODER IGBTS UND ENTSPRECHENDES HALBLEITERBAUELEMENT
PROCÉDÉ DE PRODUCTION DE MOSFETS OU IGBTS VERTICAUX À GRILLE EN TRANCHÉE ET DISPOSITIF SEMICONDUCTEUR CORRESPONDANT

(43) Date of publication of application: 02.08.2023
(73) Proprietor: Hitachi Energy Ltd, 8050 Zürich (CH)
(72) Inventor: Buitrago, Elizabeth, 5210 Windisch (CH); Bellini, Marco, 8005 Zürich (CH); Vitale, Wolfgang Amadeus, 6340 Baar (CH)
(74) Representative: Epping - Hermann - Fischer

(56) References cited:
- CN-A- 110 581 071
- JP-A- 2010 232 627
- US-A1- 2009 246 923
- US-A1- 2010 155 833
- US-A1- 2013 200 451
- US-A1- 2015 145 028
- US-A1- 2020 066 579

## Description

The present disclosure relates to a method for producing a semiconductor device being a trench-gate insulated gate transistor.

Document US 2010/155833 A1 relates to a semiconductor device having vertical type MOSFET and a manufacturing method thereof. Document CN 110 581 071 A relates to a method for reducing production cost of trench-type DMOS. Document US 2020/066579 A1 relates to a power semiconductor device with reliable verifiable p-contact. Document US 2009/246923 A1 relates to a method of forming shielded gate FET with self-aligned features.

There is a need for an improved method for producing a semiconductor device, e.g. for a method with a low number of method steps and/or for a method which allows the production of small structures. Furthermore, there is a need for an improved semiconductor device, e.g. for a semiconductor device with small structures.

Embodiments of the disclosure relate to an improved method for producing a semiconductor device. The disclosure also relates to semiconductor devices manufactured using the improved method.

The invention, however, is only defined by the claims and concerns the method of manufacturing. . Therefore, portions of the description and drawings relating to embodiments not covered by the claims are not presented as embodiments of the invention, but as examples useful in understanding the invention.

The invention concerns a method of manufacturing a semiconductor device according to claim 1.

The semiconductor body may comprise or may consist of Si or SiC. The top side of the semiconductor body may run parallel to a main extension plane of the semiconductor body. A lateral direction is herein defined as a direction parallel to the top side and/or parallel to the main extension plane of the semiconductor body. A vertical direction is herein defined as a direction perpendicular to the top side and/or main extension plane of the semiconductor body.

According to the invention, at least two trenches extend from the top side into the semiconductor body. All features disclosed here and in the following for one trench are to be understood as to applying to two trenches and are also disclosed for all other trenches of the semiconductor device. For instance, each trench may overlap with a first section of the mask.

For example, the at least one trench has a depth, measured in vertical direction, of at least 1 µm and at most 10 µm or at least 2 µm and at most 6 µm. The maximum width of the trench, measured in lateral direction, may be at most 2 µm or at most 1 µm. For instance, the width of the trench is smaller than its depth. The trench may taper in vertical direction from the top side into the semiconductor body.

The functional portion is a portion of the semiconductor body provided for an electrical functionality of the final semiconductor device. For example, during operation of the semiconductor device, electrons or holes are transported through the functional portion, e.g. in vertical direction. The functional portion is laterally adjacent to the trench. This means that the functional portion is located directly next to the trench in lateral direction. Thus, a lateral surface of the trench is at least partially formed by the functional portion. The functional portion may form part of the top side and, starting from the top side, may extend into the semiconductor body.

The mask may be formed of a semiconductor material and/or an insulating material. For example, the mask comprises or consists of Si or SiO₂. A first section of the mask overlaps with the trench. This means that in plan view of the top side, the first section partially or completely covers the trench. For example, the first section of the mask only partially covers the trench so that a portion of the trench adjacent to the functional portion projects beyond the first section of the mask in lateral direction and towards the functional portion. In other words, the step between the first section and the second section of the mask may be formed in the region of the trench, i.e. the step may overlap with the trench.

The second section of the mask overlaps with the functional portion, e.g. covers the functional portion in plan view of the top side at least partially. For example, the second section completely overlaps the functional portion. The second section of the mask is thinner than the first section of the mask. For example, the first section is at least 2-times or at least 3-times or at least 5-times as thick as the second section. In the first section of the mask, the thickness may be at most 2 µm and/or at least 0.5 µm. In the second section of the mask, the thickness may even be zero so that the top side of the semiconductor body is exposed in the second section. Thus, the second section of the mask may be a hole or recess of the mask. The thicknesses of the mask are herein measured in vertical direction. Everything on the top side during the implantation of the first-type dopants may be considered as being part of the mask.

In the step of forming the first region of the first conductivity type, the first region may be formed directly under the top side, i.e. adjacent to the top side. For forming the first region, the first-type dopants may first be implanted and may thereby accumulate at the top side. Then, a drive process or annealing process, respectively, may be performed, in which the first-type dopants further drift into the semiconductor body so that the first region expands.

The first conductivity type may be either electron conduction or hole conduction, i.e. the first region may be either n-doped or p-doped. The first-type dopants are, accordingly, n-type dopants or p-type dopants. The second conductivity type is the opposite conductivity type of the first conductivity type, i.e. either hole conduction or electron conduction. The second-type dopants are, accordingly, p-type dopants or n-type dopants. The first-type dopants are, e.g., As or P. The second-type dopants are, e.g. Boron (B).

According to the invention, a protection layer is deposited prior to forming the second region of the second conductivity type. This protection layer may comprise or consist of an electrically insulating material, like SiO₂. The protection layer may be deposited by sputtering or chemical vapor depositions, for example. For example, the protection layer is deposited as a contiguous layer without interruptions. The protection layer may be deposited conformally on the mask such that it form-fittingly covers the first section, the second section, as well as the step there between. In plan view of the top side, the protection layer may completely cover the trench and/or the functional portion. For example, the protection layer is deposited with a constant layer thickness. For example, a layer thickness of the protection layer is between 50 nm and 200 nm inclusive, e.g. between 80 nm and 150 nm inclusive.

In the step of forming the second region of the second conductivity type, the second region is formed directly under the top side, i.e. adjacent to the top side. Also here, for forming the second region, firstly the second-type dopants may be implanted and may accumulate at the surface of the semiconductor body and, then, by applying a drive process or annealing process respectively, the second-type dopants may further drift into the semiconductor body. Thereby, the second region may expand. The second-type dopants are, e.g., Boron.

In the step of forming the second region, the second-type dopants, in contrast to the first-type dopants, have to pass through the protection layer. In a region where the second-type dopants have a longer travel path through the protection layer and, if applicable, the mask, the effective implantation intensity of second-type dopants reaching the top side is reduced compared to regions of the top side where the travel path through the protection layer and/or the mask is shorter. The length of the travel path through the protection layer is also determined by the profile of the mask. For example, when using a directed implantation method with an implantation direction perpendicular to the top side, the effective implantation intensity in the region overlapping with the first section of the mask and in the region overlapping with the second section of the mask close to the step is reduced compared to the region overlapping with the second section of the mask spaced from the step by at least the layer thickness of the protection layer. The difference in the travel path is determined by the height of the step. The width of the region of the top side overlapping with the second section and having the reduced effective implantation intensity is mainly determined by the layer thickness of the protection layer.

Thus, in the method of the invention, by controlling the layer thickness of the protection layer and the step height, it is possible to control which region of the top side overlapping with the second section is exposed to the reduced effective implantation intensity. On the other hand, by controlling which regions are exposed to the reduced effective implantation energy, the area over which the first region is preserved, i.e. not converted into the second region, can be controlled.

Therefore, with the method of the invention, at most one lithography step is needed to form a mask. With the help of this mask, two regions of different conductivity type can be formed laterally next to each other with well-defined locations and sizes. Before depositing the protection layer, the mask is used to form a first region adjacent to a trench. The deposition of the protection layer then effectively forms a self-aligned mask with which the second region can be formed such that at least a part of the first region adjacent to the trench is preserved. The width of the preserved part of the first region can, e.g., be mainly controlled by the layer thickness of the protection layer. Thus, the method allows the amount of lithography steps to be reduced and allows doped regions to be formed with very small structural sizes.

According to the invention, at least two trenches extend from the top side into the semiconductor body. The two trenches are laterally spaced from each other. The functional portion is arranged laterally between the two trenches. For example, the functional portion is adjacent to each of these two trenches. For instance, the two trenches are neighboring trenches, i.e. there is no further trench laterally between them. A functional portion being arranged between two trenches is herein also referred to as a channel portion or mesa. The layer thickness of the protection layer is, e.g., at most the maximum width of the functional portion, e.g. at most half or at most 1/3 or at most 1/4 of the maximum width.

According to a further embodiment, each trench overlaps with a respective first section of the mask. Each trench may be assigned a first section of the mask on a one-to-one basis. The first sections assigned to the trenches may each be formed as described above. All first sections may have the same thickness.

According to a further embodiment, the first sections of the mask are laterally offset with respect to the functional portion. In other words, the first sections do not overlap with the functional portion.

According to the invention, a directed implantation method is used for implanting the first-type dopants. For example, firstly, the implantation is done with a tilt angle α which is greater than 0° (first implantation step). Afterwards, the implantation may be done with a tilt angle α which is smaller than 0° (second implantation step). In other words, the component of the implantation direction parallel to the top side is reversed when switching from the first implantation step to the second implantation step. For instance, the tilt angle is equal in magnitude in the first and second implantation step. For example, the implantation direction is mirrored from the first implantation step to the second implantation step. The mirror plane may be a plane running perpendicularly to the top side and parallel to the trenches.

The tilt angle α of the implantation is herein defined as the angle between the main implantation direction and a normal of the top side. For example, the tilt angle α in the first implantation step is larger than 10° and is smaller than -10° in the second implantation step.

The consequence of the tilted implantation is that a certain region of the functional portion is shadowed by the first sections of the mask. Thus, by using the above described two step tilted implantation process, a center region of the functional portion arranged centrally between the two trenches is less doped with the first-type dopants than edge regions closer to the two trenches. In other words, the doping profile of the first region before the second region is formed is such that the doping concentration in the center between the two trenches is smaller than closer to the trenches. This doping profile is, e.g. also preserved after the drive process in which the dopants drift.

The center region of the functional portion having the lower doping concentration can be more easily converted into the second region of the opposite conductivity type than the edge regions of the functional portion. For example, when forming the second region, a previously contiguous first region of the first conductivity type extending from one trench to the other is converted, in its center, into the second region of the second conductivity type and only the edge regions of the first region remain. Thus, effectively, the initially contiguous first region is divided into two first regions each adjacent to a trench. Each of these first regions, on its own, may be contiguous.

According to a further embodiment, the tilt angle alpha is chosen to have an absolute value of latan((D+W)/H)| ± 10° or ± 5°, i.e. with a maximum deviation of 10° or 5°. Herein, H is the thickness of the mask in the first section, W is the width of the functional portion at the top side measured in lateral direction, i.e. the lateral distance between the two trenches, D is the distance in lateral direction between a first section of the mask and the functional portion. In other words, D is the distance between a step of the mask and the lateral surface of the trench formed by the functional portion. In case the step is retracted from the lateral surface of the trench in the direction towards the trench, D is positive, otherwise D is negative. Herein, D is defined, e.g., as the shortest distance between a first section of the mask and the functional portion.

With such a tilt angle α, the highest implantation intensity of first-type dopants reaching the functional portion can be adjusted to be in the regions close to the trenches. The rest of the functional portion, particularly the center region of the functional portion, is shaded by the first sections of the trenches.

According to a further embodiment, a directed implantation method is used for implanting the second-type dopants. For example, the main implantation direction is then chosen perpendicular to the top side or, in other words, the tilt angle is 0°. As already described before, with such a tilt angle α, the second-type dopants have a long travel path through the protection layer in the region close to the step so that in this region less second-type dopants reach the semiconductor body than, e.g., in the center of the functional portion. In this way, the first region can be preserved at least close to the trenches.

According to a further embodiment, the layer thickness d of the protection layer is greater than the distance D between the first section of the mask and the functional portion. For instance, the difference d-D is at least 50 nm or at least 100 nm. For example, when the step in the mask is retracted towards the trench, i.e. when the first section laterally projects beyond the functional portion and partially overlaps with the trench, a protection layer with a layer thickness d > D is useful to sufficiently protect the first region adjacent to the trench from being completely converted into the second region.

According to a further embodiment, after having provided the semiconductor body with the mask and before forming the first region, a third region of the second conductivity type is formed in the semiconductor body, particularly in the functional portion. Forming the third region comprises implanting second-type dopants through the top side into the semiconductor body. The second-type dopants for forming the third region may be of the same material as the ones for forming the second region, e.g. of B. Also here, after implantation, a drive process or an anneal process, respectively, may be performed. The implantation of second-type dopants for forming the third region may be done before and/or after forming the trenches in the semiconductor body. The implantation of second-type dopants for forming the third region may be done before and/or after forming the mask on the semiconductor body.

At least within the functional portion, the third region may be formed directly under the top side, i.e. adjacent to the top side. A part of the third region may be converted into the first region later on.

According to a further embodiment, after forming the second region, a main electrode is applied onto the top side in order to electrically contact the semiconductor body in the region of the functional portion. Before applying the main electrode and after forming the second region, an etch process may be performed in order to remove the protection layer at least in the region of the functional portion and in order to expose the top side. During this etch process, part of the mask may also be removed. However, particularly in the region of the trenches, where the mask is formed by the first sections having a larger thickness, remnant structures of the mask may be preserved and may form part of the final semiconductor device.

The main electrode may be applied such that it is in direct electrical contact with the first region and/or with the second region. The main electrode may be formed of metal.

According to a further embodiment, the trench is filled with the electrically conductive material. The electrically conductive material may be electrically isolated from the semiconductor body by an insulation layer applied on surfaces of the trenches. Particularly lateral surfaces of the trenches, which delimit the trenches in lateral direction, may be covered by the insulation layer in order to electrically isolate the functional portion from the conductive material. The conductive material is, e.g., highly-doped polysilicon, like n-type polysilicon. The insulation layer may be formed of SiO₂.

When providing the semiconductor body, i.e. before implanting the first-type dopants, the trenches may already be filled with the electrically conductive material and/or the insulation layer.

According to the invention, the semiconductor device is an insulated gate transistor. For example, the semiconductor device is a MOSFET or an Insulated Gate Bipolar Transistor (IGBT). The main electrode may then be a source electrode or emitter electrode, respectively. The first region may be a source region or emitter region, respectively, of the semiconductor body. On the bottom side of the semiconductor body, opposite to the top side, a further main electrode may be applied which may constitute a drain electrode or collector electrode, respectively.

According to the invention, the trench is part of the insulated gate. For example, the electrically conductive material in the trench is electrically connected to a gate electrode. The gate electrode may be applied on the top side. An insulation between the gate electrode and the semiconductor material of the functional portion may be realized by the insulation layer in the trench.

According to a further embodiment, in the step of providing the semiconductor body, the functional portion is of the second conductivity type, at least directly under the top side, i.e. adjacent to the top side. For example, an implantation process with second-type dopants has been performed beforehand in order to make this part of the functional portion to be of the second conductivity type.

According to a further embodiment, the semiconductor body comprises at least one further functional portion laterally arranged between two trenches. The further functional portion may herein also be referred to as dummy functional portion or dummy channel portion or dummy mesa. The further functional portion is, for instance, spaced from the functional portion by at least one trench. For example, the functional portion and the further functional portion are separated from each other in lateral direction by exactly one trench.

According to a further embodiment, a maximum width of the further functional portion is different from a maximum width of the functional portion. For example, the further functional portion has a smaller maximum width than the functional portion. By way of example, a maximum width of the further functional portion is at most 80 % or at most 60 % of the maximum width of the functional portion.

According to a further embodiment, implanting the first-type dopants is done with such a tilt angle α that the further functional portion is completely shaded by a first section of the mask. In other words, the further functional portion, i.e. the top side formed by the further functional portion, completely lies in the shadow of a first section. This first section of the mask may overlap with a trench adjacent to the further functional portion. For example, when performing the two-step tilt implantation process, in each of these implantation steps, the further functional portion is completely shaded by a first section of the mask. In one implantation step the further functional portion is then shaded by the first section on the trench on the left side of the further functional portion and, in the other implantation step, the further functional portion is shaded by the first section on the trench on the right side of the further functional portion.

The fact that the further functional portion is completely shaded by a first section of the mask does not mean that no first-type dopants reach into the further functional portion since a portion of the first-type dopants may, e.g., pass through the first section of the mask or may be implanted due to the random nature of the implantation process. Rather, "completely shaded" means that each straight line enclosing the angle α with a normal of the top side and passing through the top side in the area of the further functional portion runs at least partially through a first section of the mask. As a consequence of this, during implanting the first type dopants, the conductivity type in the further functional portion at the top side is, e.g., not changed.

Even though the invention as claimed only concerns a method of manufacturing a semiconductor device, a semiconductor device resulting from the method of the invention is also described below. All features disclosed for the method are also disclosed for the semiconductor device.

The semiconductor device comprises a semiconductor body having a top side and at least one trench extending from the top side into the semiconductor body. A functional portion of the semiconductor body is arranged laterally adjacent to the trench. A first region of the functional portion at the top side is of a first conductivity type and is adjacent to the trench. A second region of the functional portion at the top side is of a second conductivity type. The first region is arranged laterally between the trench and the second portion and is adjacent to the second portion.

In the device resulting from the inventive method, a remnant structure of a mask is arranged on the top side and overlaps with the trench. This is an indication that the herein specified method has been used to produce the semiconductor device.

There may be a plurality of remnant structures of the mask distributed over the top side. For example, a remnant structure of the mask is arranged on several trenches or on each trench. All remnant structures may have the same thickness within the limits of the manufacturing tolerance. The remnant structures may be free of any functionality in the semiconductor device. For example, the remnant structures comprise traces of a material removal, like an etch process. The remnant structures may comprise or consist of a semiconductor material, like Si or SiC, or of an insulator, like SiO₂. The remnant structure(s) may be vestigial structure (s) .

The functional portion is arranged laterally between two trenches. A first region may be formed adjacent to each of the trenches. The first regions may be laterally spaced from each other by the second region. Each first region may, on its own, be contiguous.

The width of the functional portion measured in lateral direction is at most 1.5 µm or at most 1.2 µm or at most 1 µm or at most 0.8 µm. The width of the first region between the second region and the trench may be at most 300 nm or at most 200 nm or at most 100 nm. For example, the ratio of the depth of the trenches to the width of the functional portion is at least 3:1.

Such narrow functional portions (narrow mesa) with first regions of a first conductivity type and second regions of a second conductivity type can be produced with the production method described herein. Indeed, particularly thanks to the reduction of masking and the associated alignment steps, the width of the functional portion can be chosen to be very small. Like this, alignment requirements are kept at a minimum for a given lithography technology. Functional portion width reduction lowers on-state losses because of the increased plasma concentration. Thanks to the fine pattern production of first and second regions achieved with the method described herein, it is possible to reduce the functional portion width to, e.g., 0.8 um or less.

The remnant structure of the mask is a Si-structure, i.e. consists of Si.

The trenches are filled with an electrically conductive material which is electrically isolated from the semiconductor body by an insulation layer applied on surfaces of the trench.

A main electrode is on the top side and in electrical contact with the functional portion, particularly in electrical contact with the first region and/or the second region of the functional portion.

A gate electrode is arranged on the top side and in electrical contact with the electrically conductive material in the trench. On the bottom side of the semiconductor body, opposite to the top side, a further main electrode may be arranged and may be in electrical contact with the semiconductor body.

Hereinafter, the method for producing a semiconductor device and the semiconductor device will be explained in more detail with reference to drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figure 1 shows a flowchart of an exemplary embodiment of the method for producing a semiconductor device,
Figures 2 to 21 and 23 show different positions in an exemplary embodiment of the method for producing a semiconductor device,
Figures 22 and 24 shows an example of a semiconductor device manufactured using the method according to the present invention,
Figure 25 shows a position in a further exemplary embodiment of the method for producing a semiconductor device, and
Figure 26 shows a further example of a semiconductor device manufactured using the method according to the present invention.

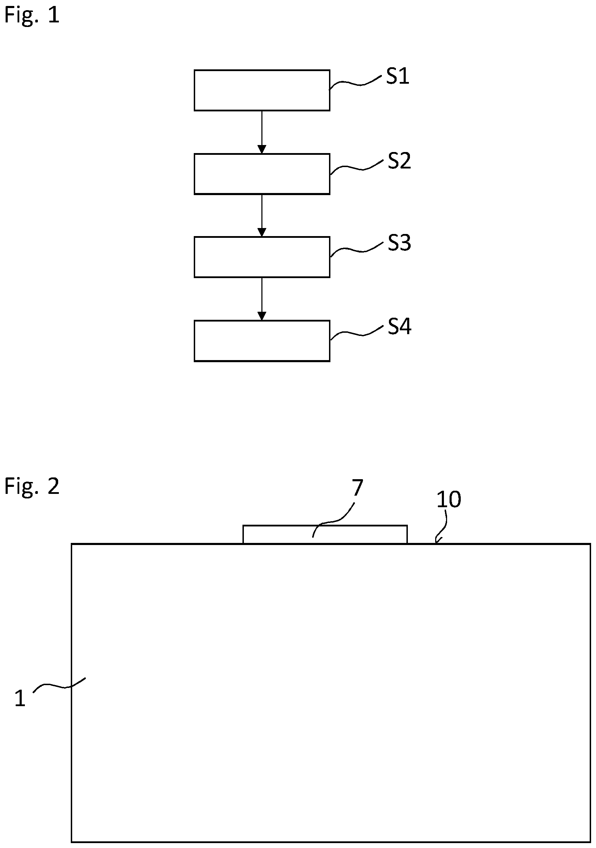

Figure 1 shows a flowchart of an exemplary embodiment of the method for producing a semiconductor device. In a step S1, a semiconductor body with a mask on its top side is provided. At least one trench extends from the top side into the semiconductor body and a functional portion of the semiconductor body is formed laterally adjacent to the trench. The mask is thicker in a first section overlapping with the trench than in a second section overlapping with the functional portion. In a step S2, a first region of a first conductivity type is formed in the functional portion on the top side and adjacent to the trench. Forming the first region comprises implanting first-type dopants into the functional portion through the top side. In a step S3, a protection layer is deposited onto the mask. The protection layer laterally extends over the trench and the functional portion. In a step S4, a second region of a second conductivity type is formed under the top side. Forming the second region comprises implanting second-type dopants through the protection layer and through the top side into the functional portion. At least a part of the first region adjacent to the trench is thereby preserved.

A semiconductor body 1 is provided in the position of an exemplary embodiment of the method shown in figure 2. The semiconductor body 1 has a top side 10 parallel to a main extension plane of the semiconductor body 1. For example, the semiconductor body 1 consists of Si or SiC. The semiconductor body 1 may be slightly doped so that it is of a first conductivity type. In the following, as an example, the first conductivity type is assumed to be electron conduction and the according doping is n-type doping. Hence, the semiconductor body 1 is slightly n-doped. On the top side 10, a mask 7, e.g. of a photoresist, is formed. The structure of the mask 7 is, e.g., generated with help of photolithography.

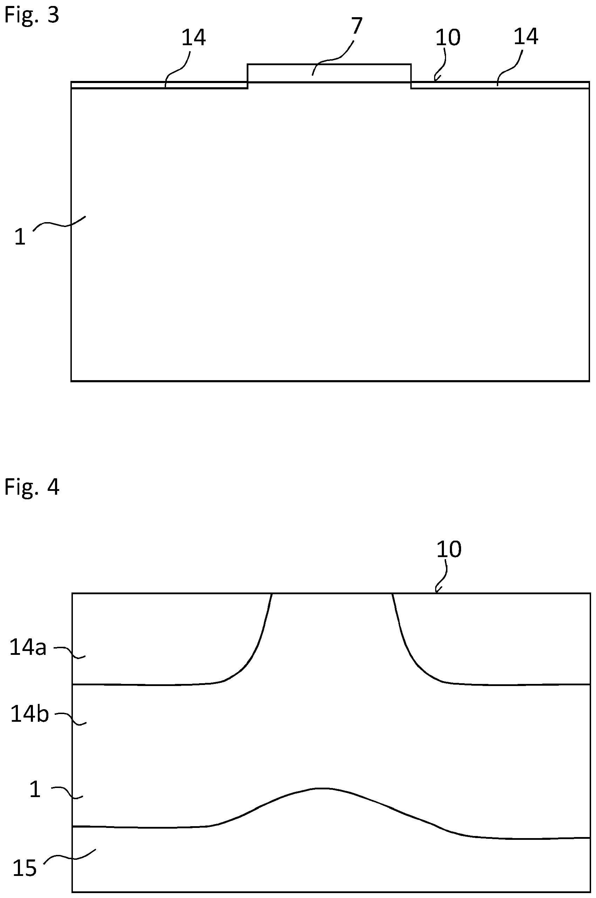

In the position of figure 3, an implantation process has been performed in which second-type dopants in the form of p-type dopants, e.g. Boron, have been implanted through the top side 10 into the semiconductor body 1. The second-type dopants have accumulated in the region directly under the top side 10 and have formed a p-doped region 14 (herein called third region 14). In figure 3, the doping concentration in the third region 14 is, e.g., approximately 1·10¹⁹ cm⁻³. The third region 14 is predominately or only formed in the regions uncovered by the mask 7.

Figure 4 shows a position after a drive process or annealing process, respectively, has been performed by which the second-type dopants have further drifted into the semiconductor body 1. Thereby, the p-doped third region 14 has expanded into the semiconductor body 1 so that two laterally spaced p-wells have formed. In figure 4, the doping profile of the third region 14 is illustrated with the help of two sections 14a, 14b with different doping concentrations. Section 14a has a greater doping concentration than section 14b. For instance, section 14a has a doping concentration of between approximately 8.3·10¹⁶ cm⁻³ and approximately 1.7·10¹⁸ cm⁻³ and section 14b has a doping concentration of between approximately 2.1·10¹⁴ cm⁻³ and approximately 8.3·10¹⁶ cm⁻³. In reality, the doping concentration may gradually increase from the lower part of section 14b to the upper part of section 14a.

A fourth region 15 of the semiconductor body 1 remains n-doped, i.e., during the drive process this region of the originally n-doped semiconductor body 1 is not converted into a p-doped region. For example, the doping concentration in the fourth region 15 is approximately 1·10¹³ cm⁻³.

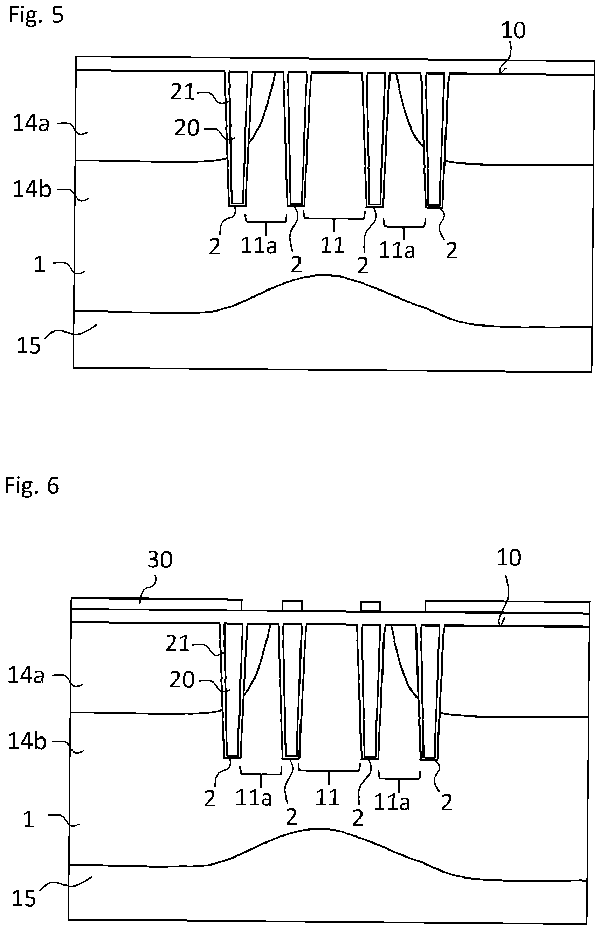

Figure 5 shows a position in the method in which a plurality of trenches 2 is introduced into the semiconductor body 1. Each trench 2 extends from the top side 10 into the semiconductor body 1 and thereby tapers in the direction from the top side 10 into the interior of the semiconductor body 1. The surfaces of the trenches 2 are covered with an electrically insulation layer 21 which also covers the top side 10 of the semiconductor body 1. The insulation layer 21 is, e.g., formed of SiO₂. Furthermore, the trenches 2 are filled with an electrically conductive material 20, e.g. highly-doped polysilicon.

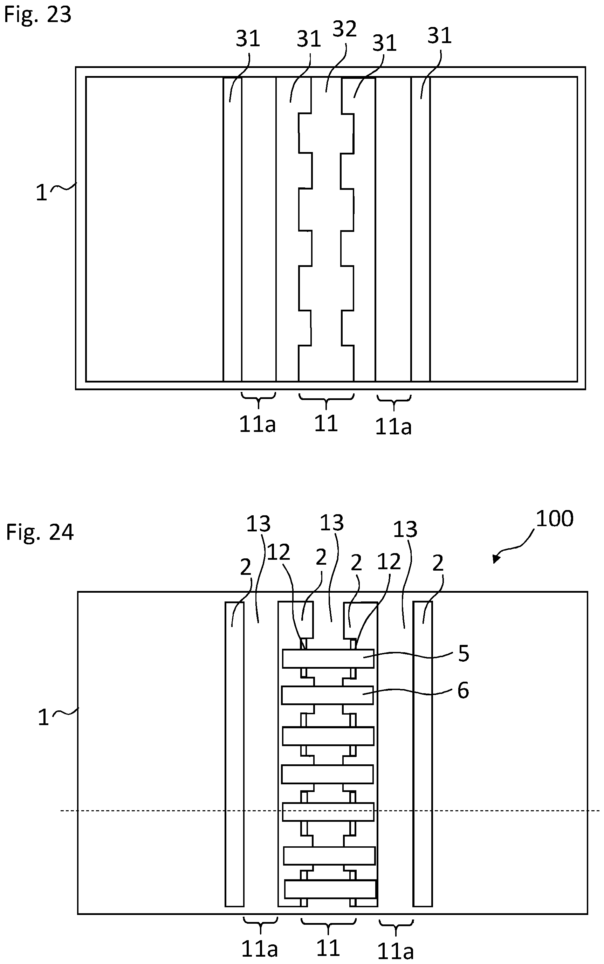

A functional portion 11, 11a, also called channel portion or mesa, is formed laterally between each pair of trenches 2. The functional portion 11 between the two inner trenches 2 is herein referred to as functional portion 11, whereas the functional portions 11a on the left and right side of the functional portion 11 are herein referred to as further functional portions 11a or dummy functional portions 11a, respectively. The maximum width of the functional portion 11 is greater than the maximum width of the dummy functional portions 11a (see also figure 23, showing the semiconductor body 1 in plan view of the top side 10).

In figure 6 an auxiliary mask 30, e.g. of a photoresist, is formed on the top side 10 of the semiconductor body 1. Structuring of the auxiliary mask 30 has been done, for instance, with the help of a photolithography process. The structuring has been done such that in the regions overlapping with the functional portions 11, 11a, the photoresist 30 is completely removed such that the insulation layer 21 is exposed. The photoresist 30 is not completely removed in the regions overlapping with the trenches 2.

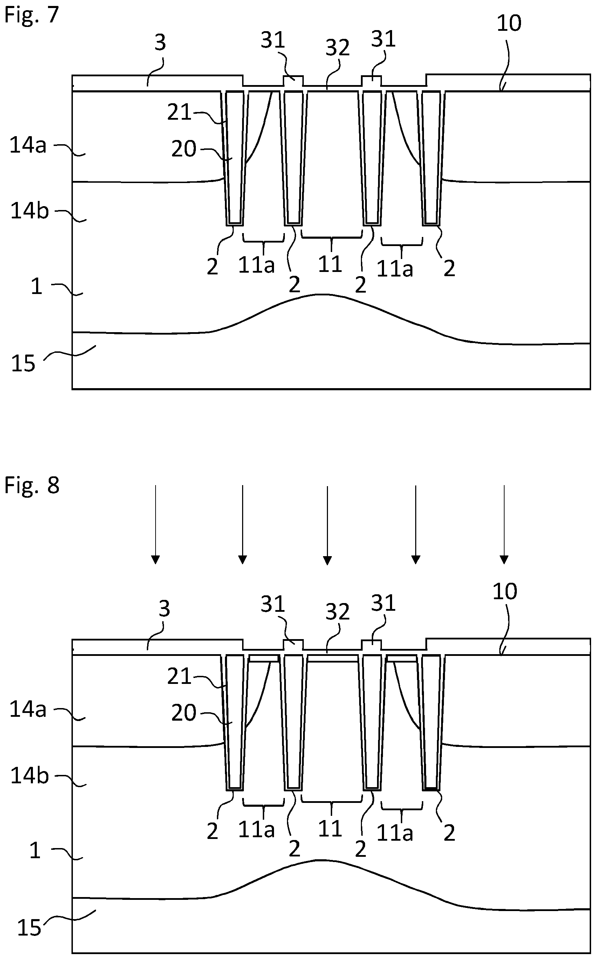

Figure 7 shows a position in which an etching process has been performed. In this etching process, the insulation layer 21 in the regions overlapping with the functional portions 11, 11a has been etched more strongly than in in the regions protected by the photoresist 30. In this way, a mask 3 of the material of the insulation layer 21 has been formed. The mask 3 comprises first sections 31 overlapping with the trenches 2 and second sections 32 overlapping with the functional portions 11, 11a. In the first sections 31, the mask 3 is thicker than in the second sections 32.

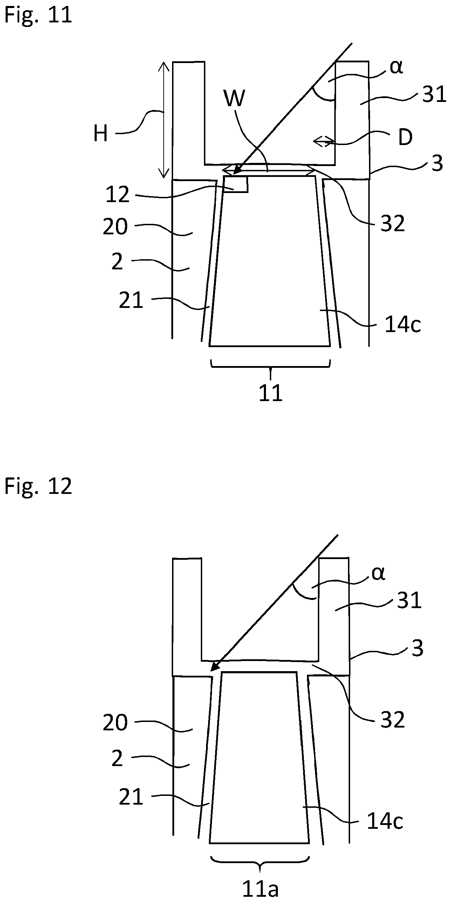

Figures 11 and 12 show detail views of the functional portions 11, 11a. Here it can be seen that the steps between the first sections 31 and the second sections 32 are retracted with respect to the lateral surfaces of the trenches 2 in the direction towards the trenches 2. Thus, the second section 32 extends over the whole functional portion 11, 11a and partially overlaps with the trenches 2.

In the position shown in figure 8, again second-type dopants are implanted through the top side 10 of the semiconductor body 1 into the functional portions 11, 11a. The second-type dopants may again be p-type dopants, e.g. Boron. The p-doping concentration under the top-side 10 is increased in the region of the functional portions 11, 11a. The implantation is done with a directed implantation method with a main implantation direction perpendicular to the top side.

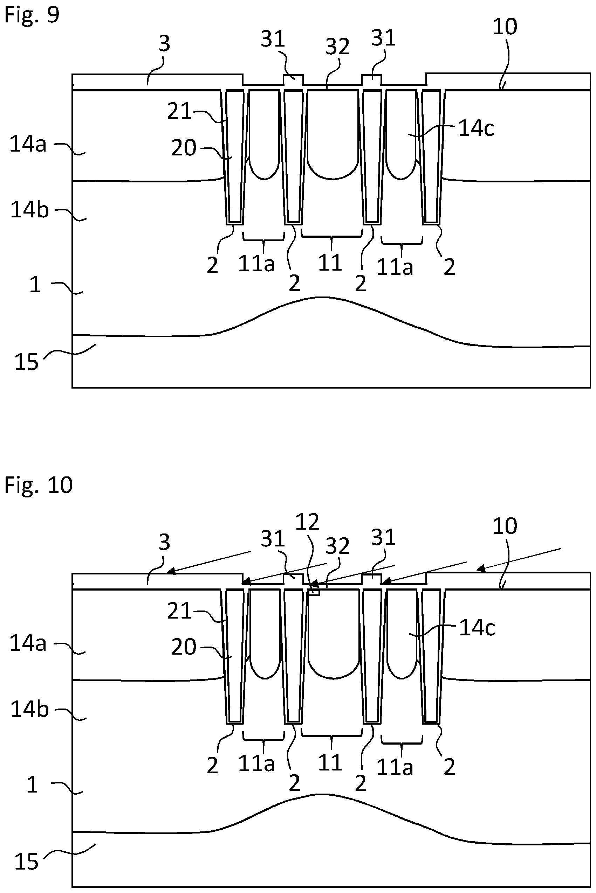

Figure 9 shows a position after a drive process in which the second-type dopants have further drifted into the semiconductor body so that the doping profile of the p-doped third region 14 has changed. The doping profile is now illustrated using three sections 14a, 14b, 14c. The doping concentration is largest in the third section 14c. The doping profile actually changes gradually from the first section 14a to the third section 14c.

In the position of figure 10, a process step is shown in which first-type dopants are implanted through the top side 10 into the functional portions 11, 11a. The first-type dopants are, in this case, n-type dopants, e.g. As or P. For implanting the first-type dopants, a directed implantation method is used with a magnitude of the tilt angle α being larger than zero, e.g. larger than 45°. Due to this tilted implantation, a region of the functional portions 11, 11a is shaded by the first sections 31 of the mask 3. This is further illustrated in figures 11 and 12, in which the functional portion 11 and the dummy functional portion 11a are shown in greater detail.

As can be seen in figure 11, the tilt angle α of the implantation is chosen to be approximately latan((D+W)/H)|, e.g. latan((D+W)/H)| ± 10°, with H being the thickness of the mask 3 in first section 31, W being the width of the functional portion 11 at the top side 10 measured in lateral direction and D being the distance in lateral direction between the first section 31 of the mask 3 and the functional portion 11. Due to this tilt angle α, a major area of the functional portion 11 is shaded by the first section 31 of the mask 3 and only a small area adjacent to a trench 2 is not shaded.

In figure 12, the dummy functional portion 11a is shown in greater detail. Due to the smaller width of the dummy functional portion 11a compared to the functional portion 11, the complete area of the dummy functional portion 11a is shaded by the first section 31 of the mask 3.

As can be seen in figures 10 and 11, due to the tilted implantation, an n-doped first region 12 is formed adjacent to trench 2. In the rest of the functional portion 11, the shading by the first section 31 is so efficient that no doping conversion appears, i.e. this rest remains p-doped. Also no conversion appears in the dummy functional portions 11a so that the dummy functional portions 11a remain p-doped at the top side 10.

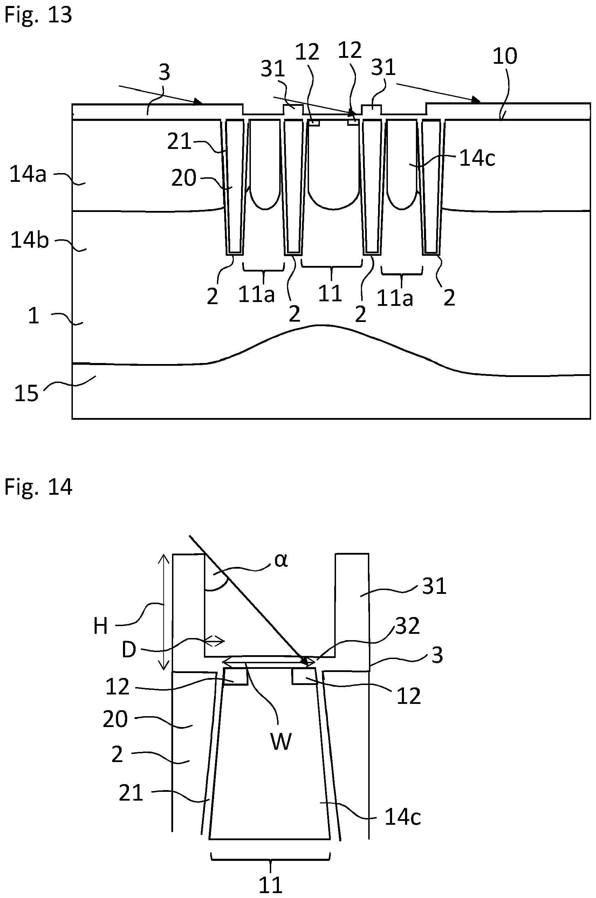

Figures 13 and 14 show a further step of the implantation of the first-type dopants, where the tilt angle α has been reversed (the implantation direction has been mirrored). Again, only a small region of the functional portion 11 adjacent to the trench 2 is transformed to an n-type first region 12. The rest is efficiently shaded by the first section 31 of the mask 3.

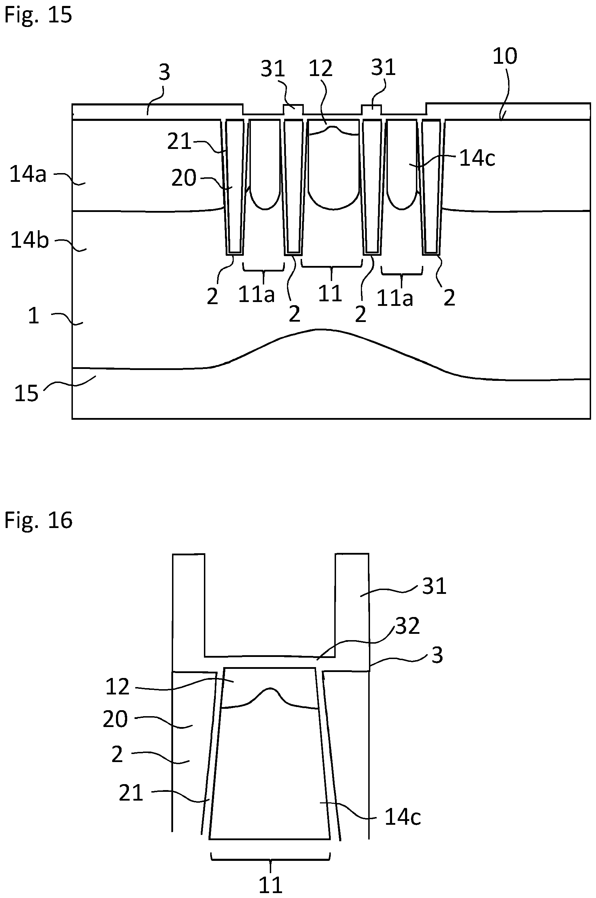

Figure 15 and 16 show a position after a drive process has been performed in which the first-type dopants have further drifted into the semiconductor body 1 and, consequently, the n-doped first regions 12 have expanded and have merged together to form one contiguous first region 12. In figures 15 and 16, the full area of the functional portion 11 directly under the top side 10 is formed by the n-doped first region 12. However, the doping concentration and the extension of the first region 12 adjacent to the trenches is larger than in the center between the trenches 2. The first region 12 has a notch in its center.

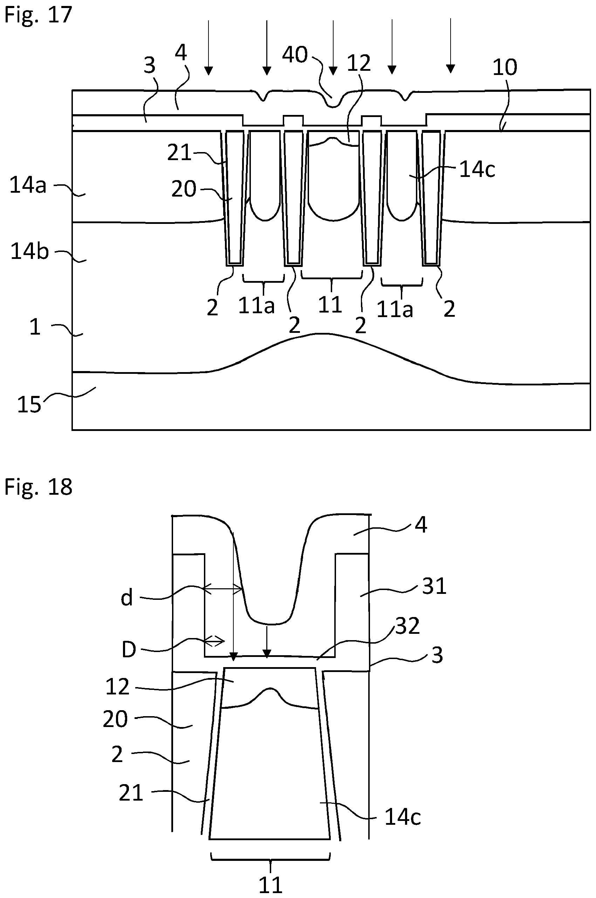

Figure 17 shows a position in the method where, as specified in the inventive method, a protection layer 4 has been conformally deposited onto the top side 10 such that the first sections 31 and the second sections 32 of the mask 3 are covered by the protection layer 4. The protection layer 4 is, e.g., of SiO₂. The protection layer 4 extends contiguously over the trenches 2 and the functional portions 11, 11a. The protection layer 4 has a layer thickness which is chosen such that a groove 40 forms in the region of the channel portion. The thickness of the protection layer 4 is, e.g., at most the width of the functional portion 11. In the area of the groove, the protection layer 4 has approximately the same thickness as in the region of the trenches 2.

It is indicated in figure 17 that an implantation process is performed in which second-type dopants, here in the form of p-type dopants, are implanted through the protection layer 4 and through the top side 10 into the semiconductor body 1. Again, a directed implantation method is used with an implantation angle of 0°, i.e. the implantation main direction is perpendicular to the top side 10.

As can be seen in figure 18, showing the functional portion 11 of figure 17 in greater detail, the travel path through the protection layer 4 close to the trenches 2 is larger than in the center of the functional portion 11. This is a result of the conformal deposition of the protection layer 4.

Therefore, the implantation intensity of second-type dopants is larger in the region of the center of the functional portion 11 than in the regions adjacent to the trenches 2. Since the layer thickness d of the protection layer 4 is greater than D, the first region 12 adjacent to the trench is efficiently shaded by the protection layer 4 against the second-type dopants so that this part of the first region 12 is protected from being converted into a p-doped region.

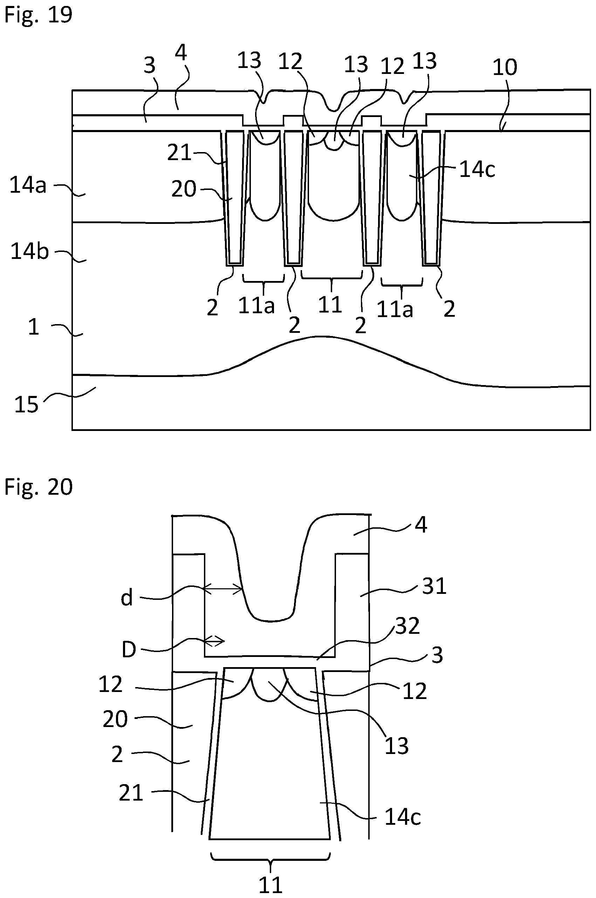

The consequence of this is shown in the positions of figures 19 and 20, in which, due to the implantation with second-type dopants, a p-type second region 13 has formed in the center of the functional portion 11 and has divided the first region 12 into two first regions 12. Thus, adjacent to the trenches 2, parts of the first regions 12 have been preserved since the amount of second-type dopants was not sufficient to completely transform the n-type first region 12 into a p-type region in these areas.

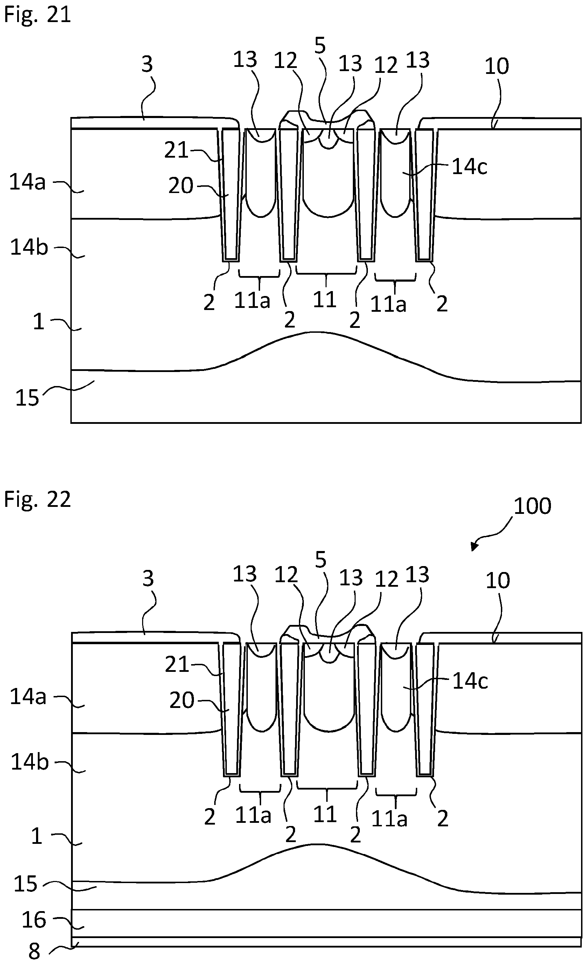

Figure 21 shows a further position in the method after the protection layer 4 has been etched away so that the functional portions 11, 11a are exposed. Furthermore, a first main electrode 5, e.g. of metal, has been deposited onto the functional portion 11 so that the first main electrode 5 electrically contacts the first regions 12 and the second region 13 of the functional portion 11. It can be further seen in figure 21 that remnants of the mask 3 are preserved in the region of the trenches 2. These remnants remain in the final semiconductor device.

Differently to what is shown in figure 21, the main electrode 5 may also contact the semiconductor body 1 in at least some regions of the dummy portions 11a.

Figure 22 shows an example of the semiconductor device 100 which is produced with the method described before. On the bottom side of the semiconductor body 1, opposite to the top side 10, a second main electrode 8 has been deposited. The second main electrode 8 is in direct electrical contact with a p-type fifth region 16 (collector layer or drain layer or anode layer) of the semiconductor body 1. The semiconductor device 100 shown in figure 22 is an IGBT.

Figure 24 shows the semiconductor device 100 of figure 22 in plan view of the top side 10 of the semiconductor body 1. As can be seen, the functional portion 11 comprises different sections with greater and smaller width, which alternate with each other. The sections of the smaller width are so narrow that in these sections n-type first regions 12 do not form or are not preserved. In these sections, gate electrodes 6 are applied which are electrically connected to the electrically conductive material 20 in the trenches 2. The dashed line in figure 24 indicates the cross-sectional plane for the representation of figure 22. The maximum width of the functional portion 11 is, e.g. 1.5 µm.

It should be emphasized that the configuration of figure 24 is indeed only one example. In a further exemplary embodiment, the alternating placement of the gate electrode 6 and the first main electrode 5 may be omitted and, instead, the first main electrode 5 is applied everywhere on top of the mask 3 and in direct contact with the functional portions 11, 11a wherever the insulating layer 3 is etched. The gate electrode 6 may then be in direct contact with the conductive material 20 in the trenches 2 only at the two ends of the "vertical stripes" formed by the functional portions 11, 11a.

In figure 23, the top side of the semiconductor body 1 is shown before the first-type dopants are implanted. As can be seen, the mask 3 comprises first sections 31 and second sections 32, wherein the second section 32 overlapping with the functional portion 11 has an alternating width.

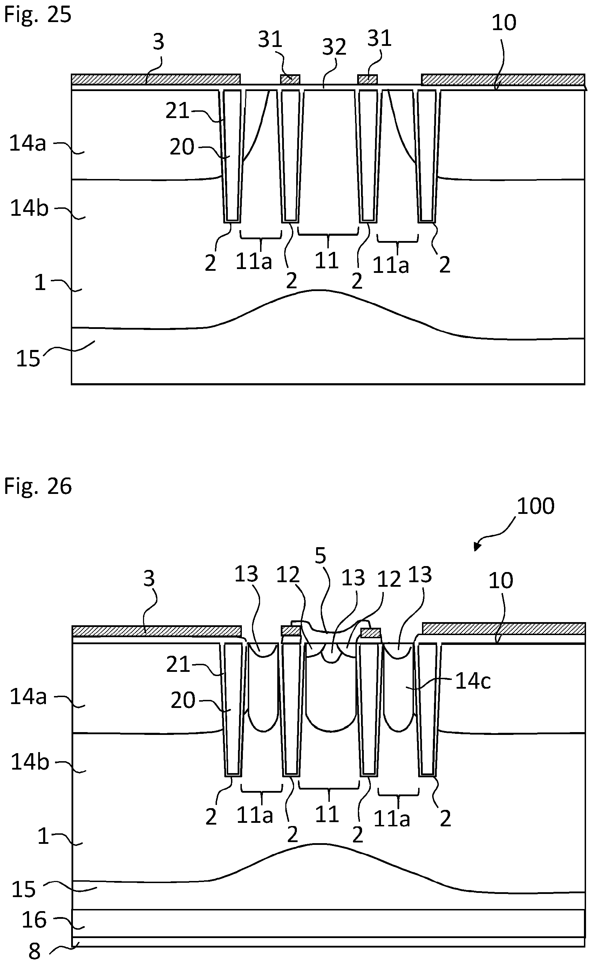

Figure 25 shows a position in a second exemplary embodiment of the method. The shown position corresponds to the position shown in figure 7. In contrast to figure 7, the mask 3 is here partially formed of silicon. The insulation layer 21 of SiO₂ is arranged between the silicon (dashed areas) and the semiconductor body 1 and covers the top side 10.

Figure 26 shows the final semiconductor device 100 with remnant structures of the mask 3 comprising or consisting of Si. With the mask 3 being at least partially of Si, in order to expose the functional portion 11, 11a the etching process can be performed more precisely due to the different selectivities of Si and SiO₂.

The embodiments shown in the Figures 1 to 26 as stated represent exemplary embodiments of the improved method and examples of the device resulting from the improved method; therefore, they do not constitute a complete list of all embodiments according to the improved method and the improved semiconductor device. Actual semiconductor devices and methods may vary from the embodiments shown in terms of arrangements for example. The scope of the invention is only defined by the appended claims.

### Reference Signs

- 1: semiconductor body
- 2: trench
- 3: mask
- 4: protection layer
- 5: first main electrode
- 6: gate electrode
- 7: mask
- 8: second main electrode
- 10: top side
- 11: functional portion
- 11a: further functional portion
- 12: first region
- 13: second region
- 14: third region
- 14a: section of third region
- 14b: section of third region
- 14c: section of third region
- 15: fourth region
- 16: fifth region
- 20: electrically conductive material
- 21: insulation layer
- 30: auxiliary mask
- 31: first section of mask 3
- 32: second section of mask 3
- 40: groove
- 100: semiconductor device
- H: thickness
- W: width
- D: distance
- d: layer thickness
- α: tilt angle
- S1 to S4: method steps

## Claims

1. Method for producing a semiconductor device (100) being an insulated gate transistor, comprising,
- providing a semiconductor body (1) with a mask (3) on a top side (10) of the semiconductor body (1), wherein
- at least two trenches (2) laterally spaced from each other extend from the top side (10) into the semiconductor body (1), wherein the trenches (2) are filled with an electrically conductive material (20) electrically isolated from the semiconductor body (1) by an insulation layer (21) applied on surfaces of the trenches (2) and wherein the trenches (2) are part of the insulated gate,
- a functional portion (11) of the semiconductor body (1) is formed laterally adjacent to the two trenches (2) and laterally between the two trenches (2),
- in first sections (31) overlapping with the trenches (2), the mask (3) is thicker than in a second section (32) overlapping with the functional portion (11);
- forming a first region (12) of a first conductivity type in the functional portion (11) under the top side (10) and adjacent to the trench (2), wherein forming the first region (12) comprises implanting first-type dopants through the top side (10) into the functional portion (11), wherein, for implanting the first-type dopants,
- a directed implantation method is used in which, firstly, the implantation is done with a tilt angle α greater than 0° and then the implantation is done with a tilt angle α smaller than 0° so that the doping concentration of the first-type dopants in the functional portion (11) is greater closer to the trenches (2) than centrally between the trenches (2);
**characterized in that**
- after forming the first region (12), depositing a protection layer (4) onto the mask (3), wherein the protection layer (4) laterally extends over the trench (2) and the functional portion (11);
- forming a second region (13) of a second conductivity type in the functional portion (11) under the top side (10),
wherein
- forming the second region (13) comprises implanting second-type dopants through the protection layer (4) and through the top side (10) into the functional portion (11),
- at least a part of the first region (12) adjacent to the trenches (2) is preserved,
- the protection layer (4) is thinner in a section where the second region (13) is to be formed than in a section where the first region (12) is to be preserved, and
- the deposition of the protection layer (4) effectively forms a self-aligned mask, wherein the width of the preserved part of the first region (12) is mainly controlled by the layer thickness of the protection layer (4).

2. Method according to claim 1, wherein
- the first sections (31) of the mask (3) are laterally offset with respect to the functional portion (11),
- the tilt angle α is chosen to have an absolute value of |atan((D+W)/H)| ± 10° with
- H being the thickness of the mask (3) in first section (31),
- W being the width of the functional portion (11) at the top side (10) measured in lateral direction,
- D being the distance in lateral direction between a first section (31) of the mask (3) and the functional portion (11).

3. Method according to any one of the preceding claims, wherein, for implanting the second-type dopants,
- a directed implantation method is used,
- the main implantation direction is perpendicular to the top side (10).

4. Method according to any one of the preceding claims, wherein
- the layer thickness d of the protection layer (4) is greater than the distance D between the first section (31) of the mask (3) and the functional portion (11) measured in lateral direction.

5. Method according to any one of the preceding claims, wherein
- after having provided the semiconductor body (1) with the mask (3) and before forming the first region (12), a third region (14) of the second conductivity type is formed in the functional portion (12) under the top side (10), wherein forming the third region (14) comprises implanting second-type dopants through the top side (10) into the semiconductor body (1).

6. Method according to any one of the preceding claims,
- after forming the second region (13), a main electrode (5) is applied onto the top side (10) in order to electrically contact the semiconductor body (1) in the region of the functional portion (11).

7. Method according to any one of the preceding claims, wherein
- the semiconductor body (1) comprises at least one further functional portion (11a) laterally arranged between two trenches (2) and spaced from the functional portion (11) by at least one trench (2),
- a maximum width of the further functional portion (11a) is smaller than a maximum width of the functional portion (11).

8. Method according to claim 7, wherein
- implanting the first-type dopants is done with such a tilt angle α that the further functional portion (11a) is completely shaded by a first section (31) of the mask (31).

## Patentansprüche

1. Verfahren zum Erzeugen einer Halbleitervorrichtung (100), bei der es sich um einen Transistor mit isoliertem Gate handelt, umfassend,
- Bereitstellen eines Halbleiterkörpers (1) mit einer Maske (3) auf einer Oberseite (10) des Halbleiterkörpers (1), wobei
- mindestens zwei lateral voneinander beabstandete Gräben (2) sich von der Oberseite (10) in den Halbleiterkörper (1) hinein erstrecken, wobei die Gräben (2) mit einem elektrisch leitfähigen Material (20) gefüllt sind, das durch eine auf die Oberflächen der Gräben (2) aufgebrachte Isolierschicht (21) von dem Halbleiterkörper (1) elektrisch isoliert ist, und wobei die Gräben (2) Teil des isolierten Gates sind,
- ein funktioneller Abschnitt (11) des Halbleiterkörpers (1) lateral an die zwei Gräben (2) angrenzend und lateral zwischen den zwei Gräben (2) angeordnet ist,
- in ersten Abschnitten (31), die sich mit den Gräben (2) überschneiden, die Maske (3) dicker ist als in einem zweiten Abschnitt (32), der sich mit dem funktionellen Abschnitt (11) überschneidet;
- Ausbilden eines ersten Bereichs (12) mit einem ersten Leitfähigkeitstyp in dem funktionellen Abschnitt (11) unterhalb der Oberseite (10) und angrenzend an den Graben (2), wobei das Ausbilden des ersten Bereichs (12) das Implantieren von Dotierstoffen eines ersten Typs durch die Oberseite (10) in den funktionellen Abschnitt (11) umfasst, wobei zum Implantieren der Dotierstoffe des ersten Typs
- ein gerichtetes Implantierungsverfahren eingesetzt wird, wobei zunächst das Implantieren mit einem Kippwinkel α von über 0° durchgeführt wird und dann das Implantieren mit einem Kippwinkel α von unter 0° durchgeführt wird, sodass die Dotierkonzentration der Dotierstoffe des ersten Typs in dem funktionellen Abschnitt (11) nahe der Gräben (2) größer ist als mittig zwischen den Gräben (2);
**dadurch gekennzeichnet, dass**
- nach dem Ausbilden des ersten Bereichs (12), Abscheiden einer Schutzschicht (4) auf die Maske (3), wobei die Schutzschicht (4) sich lateral über den Graben (2) und den funktionellen Abschnitt (11) hinaus erstreckt;
- Ausbilden eines zweiten Abschnitts (13) von einem zweiten Leitfähigkeitstyp in dem funktionellen Abschnitt (11) unter der Oberseite (10), wobei
- das Ausbilden eines zweiten Bereichs (13) das Implantieren von Dotierstoffen eines zweiten Typs durch die Schutzschicht (4) und durch die Oberseite (10) in den funktionellen Abschnitt (11) umfasst,
- mindestens ein Abschnitt des ersten Bereichs (12) angrenzend an die Gräben (2) erhalten bleibt,
- die Schutzschicht (4) in einem Abschnitt, in dem der zweite Bereich (13) auszubilden ist, dünner ist als in einem Abschnitt, in dem der erste Bereich (12) zu erhalten ist, und
- das Abscheiden der Schutzschicht (4) effektiv eine selbstausgerichtete Maske ausbildet, wobei die Breite des erhaltenen Teils des ersten Bereichs (12) hauptsächlich gesteuert wird durch die Schichtdicke der Schutzschicht (4).

2. Verfahren nach Anspruch 1, wobei
- die ersten Abschnitte (31) der Maske (3) in Bezug auf den funktionellen Abschnitt (11) lateral versetzt sind,
- der Kippwinkel α so ausgewählt wird, dass er einen Absolutwinkel von |atan((D+W)/H) | ± 10° aufweist, wobei
- H die Dicke der Maske (3) im ersten Abschnitt (31) ist,
- W die Breite des funktionellen Abschnitts (11) auf der Oberseite (10) ist, gemessen in einer lateralen Richtung,
- D der Abstand in lateraler Richtung zwischen einem ersten Abschnitt (31) der Maske (3) und dem funktionellen Abschnitt (11) ist.

3. Verfahren nach einem der vorhergehenden Ansprüche, wobei zum Implantieren der Dotierstoffe des zweiten Typs
- ein gerichtetes Implantierverfahren eingesetzt wird,
- die Hauptimplantationsrichtung senkrecht zu der Oberseite (10) ist.

4. Verfahren nach einem der vorhergehenden Ansprüche, wobei
- die Schichtdicke d der Schutzschicht (4) größer ist als der Abstand D zwischen dem ersten Abschnitt (31) der Maske (3) und dem funktionellen Abschnitt (11), gemessen in lateraler Richtung.

5. Verfahren nach einem der vorhergehenden Ansprüche, wobei
- nach dem Versehen des Halbleiterkörpers (1) mit der Maske (3) und vor dem Ausbilden des ersten Bereichs (12) ein dritter Bereich (14) vom zweiten Leitfähigkeitstyp in dem funktionellen Bereich (12) unter der Oberseite (10) ausgebildet wird, wobei das Ausbilden des dritten Bereichs (14) das Implantieren von Dotierstoffen des zweiten Typs durch die Oberseite (10) in den Halbleiterkörper (1) umfasst.

6. Verfahren nach einem der vorhergehenden Ansprüche,
- nach dem Ausbilden des zweiten Bereichs (13) wird eine Hauptelektrode (5) auf die Oberseite (10) angelegt, um den Halbleiterkörper (1) in dem Bereich des funktionellen Abschnitts (11) elektrisch zu kontaktieren.

7. Verfahren nach einem der vorhergehenden Ansprüche, wobei
- der Halbleiterkörper (1) mindestens einen weiteren funktionellen Abschnitt (11a) umfasst, der lateral zwischen zwei Gräben (2) und von dem funktionellen Abschnitt (11) durch mindestens einen Graben (2) beabstandet angeordnet ist,
- eine Höchstbreite des weiteren funktionellen Abschnitts (11a) geringer ist als eine Höchstbreite des funktionellen Abschnitts (11).

8. Verfahren nach Anspruch 7, wobei
- das Implantieren der Dotierstoffe des ersten Typs mit einem derartigen Kippwinkel α ausgeführt wird, dass der weitere funktionelle Abschnitt (11a) von einem ersten Abschnitt (31) der Maske (31) vollständig überschattet wird.

## Revendications

1. Procédé de production d'un dispositif semi-conducteur (100) qui est un transistor à grille isolée, comprenant :
- la fourniture d'un corps semi-conducteur (1) avec un masque (3) sur une face supérieure (10) du corps semi-conducteur (1),
- au moins deux tranchées (2) espacées latéralement l'une de l'autre s'étendant à partir de la face supérieure (10) dans le corps semi-conducteur (1), les tranchées (2) étant remplies d'un matériau électriquement conducteur (20) isolé électriquement du corps semi-conducteur (1) par une couche d'isolation (21) appliquée sur des surfaces des tranchées (2) et les tranchées (2) faisant partie de la grille isolée,
- une partie fonctionnelle (11) du corps semi-conducteur (1) étant formée latéralement de manière adjacente aux des deux tranchées (2) et latéralement entre les deux tranchées (2),
- dans des premières sections (31) chevauchant les tranchées (2), le masque (3) étant plus épais que dans une seconde section (32) chevauchant la partie fonctionnelle (11) ;
- la formation d'une première région (12) d'un premier type de conductivité dans la partie fonctionnelle (11) sous la face supérieure (10) et adjacente à la tranchée (2), la formation de la première région (12) comprenant l'implantation de dopants de premier type à travers la face supérieure (10) dans la partie fonctionnelle (11), pour implanter les dopants de premier type,
- un procédé d'implantation dirigée étant utilisé dans lequel, tout d'abord, l'implantation est effectuée avec un angle d'inclinaison α supérieur à 0°, puis l'implantation est effectuée avec un angle d'inclinaison α inférieur à 0° de sorte que la concentration de dopage des dopants de premier type dans la partie fonctionnelle (11) est plus grande près des tranchées (2) qu'au centre entre les tranchées (2) ;
**caractérisé en ce que**
- après la formation de la première région (12), le dépôt d'une couche de protection (4) sur le masque (3), la couche de protection (4) s'étendant latéralement sur la tranchée (2) et la partie fonctionnelle (11) ;
- la formation d'une deuxième région (13) d'un second type de conductivité dans la partie fonctionnelle (11) sous la face supérieure (10),
- la formation de la deuxième région (13) comprenant l'implantation de dopants de second type à travers la couche de protection (4) et à travers la face supérieure (10) dans la partie fonctionnelle (11),
- au moins une partie de la première région (12) adjacente aux tranchées (2) étant préservée,
- la couche de protection (4) étant plus mince dans une section où la deuxième région (13) doit être formée que dans une section où la première région (12) doit être préservée, et
- le dépôt de la couche de protection (4) formant effectivement un masque auto-aligné, la largeur de la partie préservée de la première région (12) étant principalement commandée par l'épaisseur de couche de la couche de protection (4).

2. Procédé selon la revendication 1, dans lequel
- les premières sections (31) du masque (3) étant décalées latéralement par rapport à la partie fonctionnelle (11),
- l'angle d'inclinaison α étant choisi pour avoir une valeur absolue de |atan((D+W)/H) | +- 10° avec
- H étant l'épaisseur du masque (3) dans la première section (31),
- W étant la largeur de la partie fonctionnelle (11) sur la face supérieure (10) mesurée dans la direction latérale,
- D étant la distance dans la direction latérale entre une première section (31) du masque (3) et la partie fonctionnelle (11).

3. Procédé selon l'une quelconque des revendications précédentes, pour implanter les dopants de second type,
- un procédé d'implantation dirigée étant utilisée,
- la direction principale d'implantation étant perpendiculaire à la face supérieure (10).

4. Procédé selon l'une quelconque des revendications précédentes,
- l'épaisseur de couche d de la couche de protection (4) étant supérieure à la distance D entre la première section (31) du masque (3) et la partie fonctionnelle (11) mesurée dans la direction latérale.

5. Procédé selon l'une quelconque des revendications précédentes,
- après avoir fourni le corps semi-conducteur (1) avec le masque (3) et avant la formation de la première région (12), une troisième région (14) du second type de conductivité étant formée dans la partie fonctionnelle (12) sous la face supérieure (10), la formation de la troisième région (14) comprenant l'implantation de dopants de second type à travers la face supérieure (10) dans le corps semi-conducteur (1).

6. Procédé selon l'une quelconque des revendications précédentes,
- après la formation de la deuxième région (13), une électrode principale (5) étant appliquée sur la face supérieure (10) afin d'établir un contact électrique avec le corps semi-conducteur (1) dans la région de la partie fonctionnelle (11).

7. Procédé selon l'une quelconque des revendications précédentes,
- le corps semi-conducteur (1) comprenant au moins une autre partie fonctionnelle (11a) agencée latéralement entre deux tranchées (2) et espacée de la partie fonctionnelle (11) par au moins une tranchée (2),
- une largeur maximale de la partie fonctionnelle supplémentaire (11a) étant inférieure à une largeur maximale de la partie fonctionnelle (11).

8. Procédé selon la revendication 7,
- l'implantation des dopants de premier type étant effectuée avec un angle d'inclinaison α tel que l'autre partie fonctionnelle (11a) est complètement ombrée par une première section (31) du masque (31).
